(19) Europäisches Patentamt

European Patent Office

Office européen des brevets

(11) **EP 1 187 342 A2**

(12) **EUROPEAN PATENT APPLICATION**

(43) Date of publication:
**13.03.2002 Bulletin 2002/11**

(51) Int Cl.7: **H03M 13/41**

(21) Application number: **01307265.7**

(22) Date of filing: **28.08.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **30.08.2000 JP 2000260211**

(71) Applicant: **SONY CORPORATION**
**Tokyo 141 (JP)**

(72) Inventor: **Oki, Noboru,**
**c/o Intellectual Property Department**
**Shinagawa-ku, Tokyo 141 (JP)**

(74) Representative: **Cotter, Ivan John et al**
**D. YOUNG & CO.**
**21 New Fetter Lane**
**London EC4A 1DA (GB)**

(54) **Signal processing apparatus and method, and recording medium**

(57)     A signal processing apparatus to perform maximum likelihood decoding for the data transmitted thereto at one of plural predetermined data rates. The data rates are selected in a predetermined order, and a maximum likelihood decoding process is executed to regard the data rate of the received data as the selected data rate, and a predetermined decision value is calculated on the basis of a predetermined metric value obtained through the above process. Then the decision value is compared with a first threshold value, and a decision is made, on the basis of the result of such comparison, as to whether the selected data rate is the true data rate of the received data. Subsequently, the decision value is compared with a second threshold value in response to the decision result signifying that the selected data rate is the true data rate of the received data, and another decision is made, on the basis of the comparison result, as to whether the selected data rate is the true data rate of the received data, thereby achieving efficient detection of the true data rate of the received data.

FIG.4

**Description**

The present invention relates to a signal processing apparatus, a signal processing method and a recording medium, illustrative embodiments of the present invention relate more particularly to those adapted
for achieving efficient detection of the data rate of transmitted data.

Fig. 1 is a block diagram showing an exemplary configuration of a communication system which includes a receiver 3 and is capable of transmitting and receiving data at a desired one of plural predetermined data rates.

A transmitter 1 transmits convolutional coded data to the receiver 3 via a communication channel 2 at a desired one of plural predetermined data rates.

Fig. 2 shows an exemplary transport format of the data transmitted and received in Fig. 1. In this format, a CRC code is attached to a data stream. Since the data stream is changed in length in accordance with the data rate, a last bit $n_{end}$ of the CRC code (hereinafter referred to as an end bit position) is different depending on the data rate.

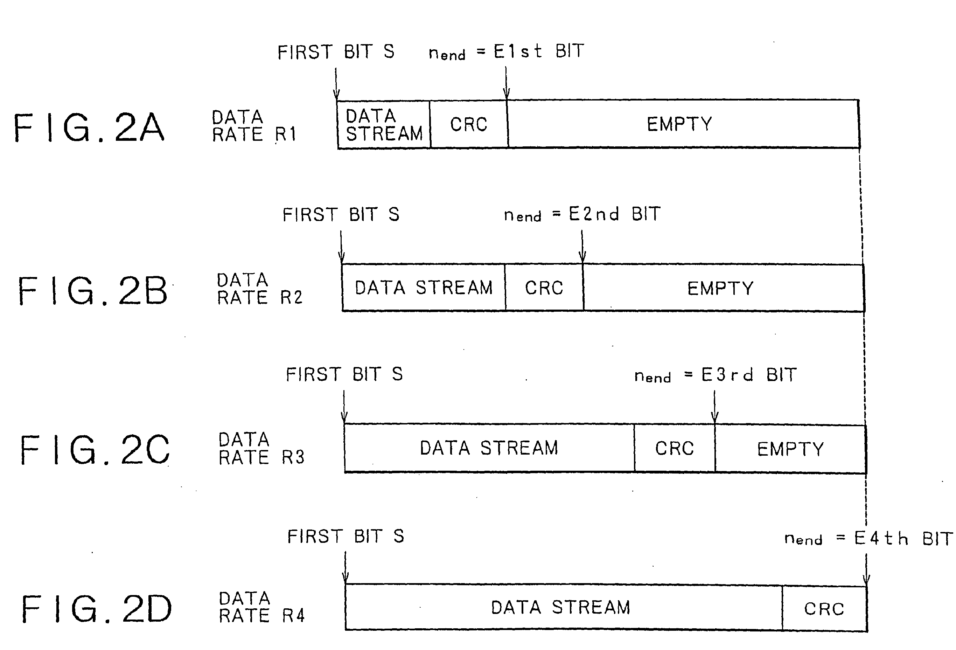

For example, in case four data rates R1 to R4 are existent as shown in Fig. 2 (where data rate R1 < data rate R2 < data rate R3 < data rate R4), the last bit $n_{end}$ at the data rate R1, R2, R3 or R4 is E1st bit (Fig. 2A), E2nd bit (Fig. 2B), E3rd bit (Fig. 2C) or E4th bit (Fig. 2D) when counted from a first bit S.

In the transport format at the data rates R1 to R3, the composition is empty from the E1st bit, E2nd bit or E3rd bit, which is the last bit $n_{end}$ at the data rate R1, R2 or R3, to the bit corresponding to the E4th bit which is the last bit $n_{end}$ at the data rate R4.

The receiver 3 executes Viterbi decoding for the data (Fig. 2) transmitted thereto from the transmitter 1 via the communication channel 2. Further the receiver 3 detects the data rate of the received data and then outputs the decoded data at the detected data rate to an unshown device.

Now an explanation will be given on the structures of the transmitter 1 and the receiver 3.

The transmitter 1 comprises a CRC (cyclic redundancy check) encoder 11, a convolutional encoder 12 and a modulator 13. The CRC encoder 11 attaches to the data stream a CRC parity bit of the data to be transmitted, and then supplies the data stream to the convolutional encoder 12.

The convolutional encoder 12 executes convolutional encoding for the data obtained from the CRC encoder 11, and then supplies the coded data to the modulator 13. Subsequently the modulator 13 modulates the data supplied thereto from the convolutional encoder 12, and transmits the modulated data to the receiver 3 via the communication channel 2.

The receiver 3 comprises a demodulator 21, a Viterbi decoder 22, a CRC decoder 23 and a data rate detector 24. The demodulator 21 demodulates the received data and supplies the demodulated data to the Viterbi decoder 22.

The Viterbi decoder 22, which is controlled by the data rate detector 24, executes Viterbi decoding for the data obtained from the demodulator 21, and then supplies the resultant data (decoded data) to the CRC decoder 23.

The Viterbi decoder 22 also supplies, to the data rate detector 24, a maximum pathmetric value, a minimum pathmetric value and a zero-state pathmetric value calculated at this time.

The Viterbi decoder 22 outputs the resultant Viterbi-decoded data to an unshown device at the data rate detected by the data rate detector 24.

The CRC decoder 23, which is controlled by the data rate detector 24, executes a CRC decision for the data obtained from the Viterbi decoder 22, and then supplies the result of such a decision to the data rate detector 24.

The data rate detector 24 controls the Viterbi decoder 22 and the CRC decoder 23 to execute Viterbi decoding and CRC decision respectively, and detects the data rate of the received data on the basis of the maximum pathmetric value, the minimum pathmetric value and the zero-state pathmetric value obtained from the Viterbi decoder 22, and also on the basis of the result of the CRC decision obtained from the CRC decoder 23.

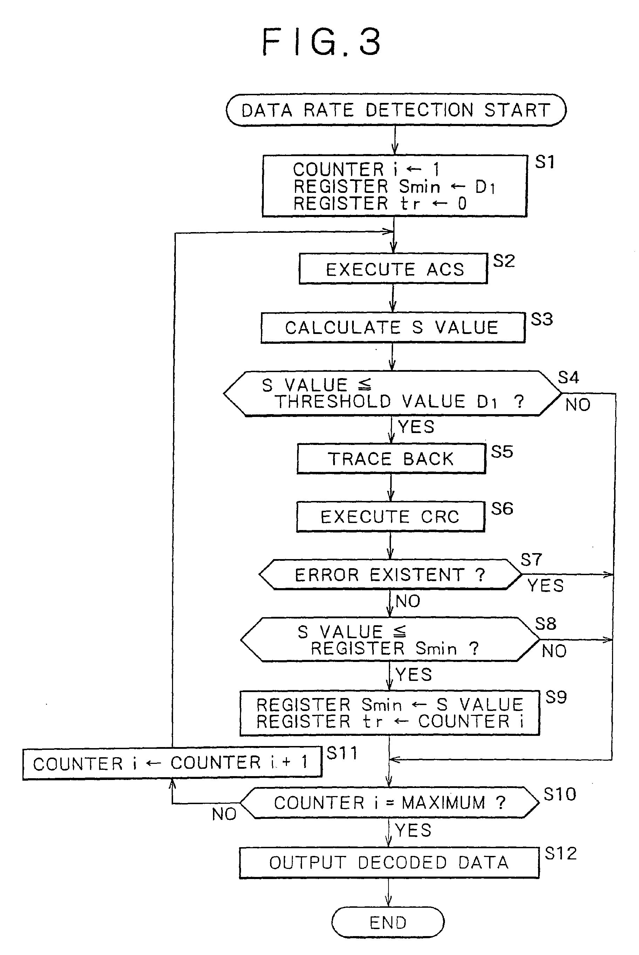

Next, the operation of the receiver 3 performed in detecting the data rate of the received data will be described below with reference to a flowchart of Fig. 3. It is supposed here that four data rates Ri (where i = 1, 2, 3, 4) are existent, as shown in Fig. 2.

First at step S1, the data rate detector 24 initializes an internal counter i to 1, a register Smin to D1 which is a predetermined threshold value stored in a threshold register 25, and a register tr to 0, respectively.

At step S2, the data rate detector 24 controls the Viterbi decoder 22 to calculate the maximum pathmetric value, the minimum pathmetric value and the zero-state pathmetric value in the range from the first bit S to the last bit $n_{end}$ of the data rate Ri identified by the value of the counter i.

Subsequently the Viterbi decoder 22 executes an ACS (add compare select) process including addition, comparison and selection, thereby calculating the maximum pathmetric value, the minimum pathmetric value and the zero-state pathmetric value. Then the Viterbi decoder 22 supplies the calculated data to the data rate detector 24.

The receiver 3 (data rate detector 24) recognizes the probable data rate Ri in advance and is capable of identifying the data rate Ri by the value of the counter i.

In this example, the data rate R1, R2, R3 or R4 is identified when the counter i indicates a value 1, 2, 3 or 4 (maximum) (i = 1, 2, 3, 4). And the maximum pathmetric value, the minimum pathmetric value and the zero-state pathmetric value are calculated in the range from the first bit S to the last Elst (Fig. 2A), E2nd (Fig. 2B), E3rd (Fig. 2C) or E4th (Fig. 2D) bit.

Thereafter at step S3, the data rate detector 24 executes a calculation of Eq. (1) shown below on the basis of the maximum pathmetric value, minimum pathmetric value and zero-state pathmetric value supplied from the Viterbi decoder 22 at step S2, thereby obtaining an S value.

$$\text{S value} = 10 \, \text{Log} \, ((a_0 - a_{min})/((a_{max} - a_{min})) \quad (1)$$

In the above equation, $a_{max}$ denotes the maximum pathmetric value, $a_{min}$ denotes the minimum pathmetric value, and $a_0$ denotes a zero-state pathmetric value. The maximum of the S value is 0, and the minimum thereof is minus infinite.

At step S4, the data rate detector 24 makes a decision as to whether the S value calculated at step S3 is equal to or smaller than the threshold value D1 or not.

When the data rate Ri identified by the value of the counter i is the true data rate of the received data, the zero-state pathmetric value calculated in the Viterbi decoder 22 is sufficiently small, so that the S value given by Eq. (1) becomes small. Meanwhile, if the data rate Ri is not the true data rate of the received data, the zero-state pathmetric value calculated in this case is not sufficiently small, so that the S value does not become small. That is, due to the decision of whether the calculated S value is equal to or smaller than the threshold value D1 or not, it becomes possible to make a decision as to whether the data rate Ri identified by the value of the counter i can be regarded or not as the true data rate of the received data (whether there is a probability of the true data rate).

The threshold value D1 is set to be relatively great so that the S value of the true data rate is not decided to be greater than the threshold value D1.

The operation proceeds to step S5 in case the result of the decision at step S4 signifies that the S value is equal to or smaller than the threshold value D1, i.e., when the data rate Ri identified by the value of the counter i at this time can be regarded as the true data rate of the received data (when there is a probability of the true data rate).

At step S5, the data rate detector 24 controls the Viterbi decoder 22 to execute a traceback process, thereby generating a data stream which ranges from the first bit S to the last bit $n_{end}$ of the data rate Ri identified by the value of the counter i (e.g., to the Elst bit when the value of the counter i is 1). Subsequently at step S6, the data rate detector 24 controls the CRC decoder 23 to make a CRC decision with respect to the data thus generated.

Thus, the Viterbi decoder 22 generates a data stream ranging from the first bit S to the last bit $n_{end}$ of the data rate Ri, and then supplies the data stream to the CRC decoder 23.

The CRC decoder 23 divides the decoded data supplied from the Viterbi decoder 22 (i.e., the decoded data from the first bit S to the last bit $n_{end}$ of the data rate Ri) by a generation polynomial, and then finds the remainder thereof.

In case the data rate Ri identified by the value of the counter i is the true data rate of the received data, there is a high probability that the remainder thus obtained is zero. However, in another case where the data rate Ri is not the true data rate of the received data, there is a high probability that the remainder is not zero.

The CRC decoder 23 notifies the data rate detector 24 of the remainder as a result of the CRC calculation.

At step S7, the data rate detector 24 makes a decision as to whether any error is existent or not in the received data, on the basis of the CRC calculation result obtained from the CRC decoder 23. That is, a decision is made as to whether any error is existent or not in the received data, in accordance with the CRC calculation result obtained when the data rate Ri indicated by the value of the counter i is regarded as the data rate of the received data. And if the CRC calculation result is not zero (i.e., when the data rate Ri is not the true data rate), it is decided that any error is existent. Meanwhile, if the CRC calculation result is zero (i.e., when the data rate Ri is probably the true data rate), it is decided that no error is existent.

If the result of the decision at step S7 signifies that no error is existent, the operation proceeds to step S8, where the data rate detector 24 makes a decision as to whether the S value calculated at step S3 is equal to or smaller than the value of the register Smin or not. Since the register Smin is initially set to D1, the S value compared therewith at step S4 and decided first as YES is naturally equal to or smaller than the value of the register Smin.

In case the result of the decision at step S8 signifies that the S value is equal to or smaller than the value of the register Smin, the operation proceeds to step S9, where the data rate detector 24 replaces the value of the register Smin with the S value calculated this time. That is, the decision at step S8 is executed to check if the S value calculated this time is the minimum or not out of the entire previous S values obtained heretofore.

Further the data rate detector 24 replaces the value of the register tr with that of the counter i obtained this time.

The operation proceeds to step S10 if the result of the decision at step S4 signifies that the S value is not equal to or smaller than the threshold value D1, or if the result of the decision at step S7 signifies that some error is existent, or if the result of the decision at step S8 signifies that the S value is not equal to or smaller than the value of the register Smin, or if the values of the registers Smin and tr have been replaced at step S9.

The data rate detector 24 makes a decision at step S10 as to whether the value of the counter i is maximum (value 4) or not. And if the result of this decision signifies that the counter value is not maximum, the operation proceeds to step S11, where the counter value is increased by 1. Then the operation returns to step S2, and the subsequent processes are executed.

In case the result of the decision at step S10 signifies that the value of the counter i is maximum, the operation proceeds to step S12, where the data rate detector 24 detects the data rate Ri, which is identified by the value of the register tr, as the true data rate of the received data. Then the data rate detector 24 controls the Viterbi decoder 22 to output the decoded data at the detected data rate Ri. The processing routine is thus completed.

Detecting the data rate of the received data is performed as described above. In this case, calculations of the S value and so forth are executed with respect to the entire data rates R1 to R4 (i.e., the processes at step S2 and subsequent ones are executed). For example, in case the data rate of the received data is R2 and the value of the counter i is 2, the final value of the register tr is determined to be 2. However, the value of the counter i is further increased to 3 and 4, and then the processes at step S2 and subsequent ones are executed.

In other words, some processes are wastefully executed to consequently fail in achieving efficient detection of the data rate.

In view of the circumstances mentioned hereinabove, the present invention seeks to realize efficient detection of the data rate.

According to one aspect of the present invention, there is provided a signal processing apparatus which comprises an execution means for selecting a plurality of data rates in a predetermined order and executing a maximum likelihood decoding process to regard the data rate of received data as the selected data rate; a calculation means for calculating a predetermined decision value on the basis of a predetermined metric value obtained through the maximum likelihood decoding process; a first decision means for comparing the decision value with a first threshold value, and making a decision, on the basis of the result of such comparison, as to whether the data rate selected by the execution means is the data rate of the received data; a second decision means for comparing the decision value with a second threshold value in response to the result of the decision by the first decision means signifying that the selected data rate is the data rate of the received data, and making another decision, on the basis of the result of such comparison, as to whether the data rate selected by the execution means is the data rate of the received data; and an output means for delivering the output data decoded by the execution means at the data rate selected by the execution means, in response to the result of the decision by the second decision means signifying that the selected data rate is the data rate of the received data.

In embodiments of the present invention, the calculation means is capable of calculating the decision value from an equation of: decision value = 10 log ((zero-state pathmetric value - minimum pathmetric value)/ (maximum pathmetric value - minimum pathmetric value)).

According to another aspect of the present invention, there is provided a signal processing method which comprises an execution step of selecting a plurality of data rates in a predetermined order and executing a maximum likelihood decoding process to regard the data rate of received data as the selected data rate; a calculation step of calculating a predetermined decision value on the basis of a predetermined metric value obtained through the maximum likelihood decoding process; a first decision step of comparing the decision value with a first threshold value, and making a decision, on the basis of the result of such comparison, as to whether the data rate selected at the execution step is the data rate of the received data; a second decision step of comparing the decision value with a second threshold value in response to the result of the decision at the first decision step signifying that the selected data rate is the data rate of the received data, and making a - decision, on the basis of the result of such comparison, as to whether the data rate selected at the execution step is the data rate of the received data; and an output step of delivering the output data decoded at the execution step at the data rate selected at the execution step, in response to the result of the decision at the second decision step signifying that the selected data rate is the data rate of the received data.

And according to a further aspect of the present invention, there is provided a recording medium containing a stored program which comprises an execution step of selecting a plurality of data rates in a predetermined order and executing a maximum likelihood decoding process to regard the data rate of received data as the selected data rate; a calculation step of calculating a predetermined decision value on the basis of a predetermined metric value obtained through the maximum likelihood decoding process; a first decision step of comparing the decision value with a first threshold value, and making a decision, on the basis of the result of such comparison, as to whether the data rate selected at the execution step is the data rate of the received data; a second decision step of comparing the decision value with a second threshold value in response to the result of the decision at the first decision step signifying that the selected data rate is the data rate of the received data, and making decision, on the basis of the result of such comparison, as to whether the data rate selected at the execution step is the data rate of the received data; and an output means of delivering the output data decoded at the execution step at the data rate selected at the execution step, in response to the result of the decision at the second decision step signifying that the selected data rate is the data rate of the received data.

With this configuration, in the signal processing apparatus, the signal processing method and the program in the recording medium of embodiments of the present invention a plurality of data rates are selected in a predetermined order, and a maximum likelihood decoding process is executed to regard the data rate of received data as the selected data rate. A predetermined decision value is calculated on the basis of a predetermined metric value obtained through the maximum likelihood decoding process, and the decision value is compared with a first threshold value, and then a decision is made, on the basis of the result of such comparison, as to whether the selected data rate is the data rate of the received data. The decision value is compared with a second threshold value in response to the result of the decision signifying that the selected data rate is the data rate of the received data, and another decision is made, on the basis of the result of such comparison, as to whether the selected data rate is the data rate of the received data. And in response to the result of the decision signifying that the selected data rate is the data rate of the received data, the decoded data are outputted at the selected data rate.

Various respective aspects and features of the invention are defined in the appended claims. Features from the dependent claims may be combined with features of the independent claims as appropriate and not merely as explicitly set out in the claims.

The invention will now be described by way of example with reference to the accompanying drawings, throughout which like parts are referred to by like references, and in which:

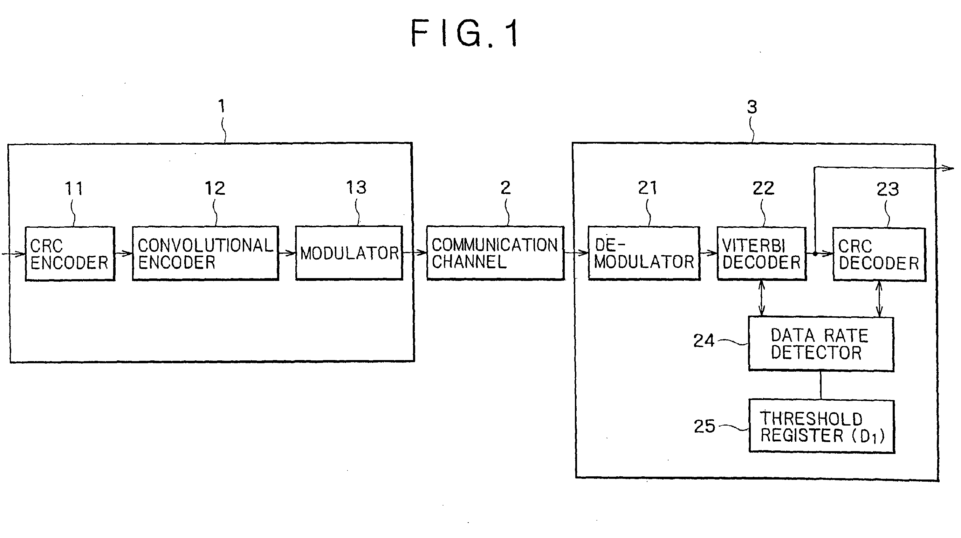

Fig. 1 is a block diagram showing a structural example of a receiver;

Figs. 2A to 2D show a transport format;

Fig. 3 is a flowchart for explaining a processing routine of data rate detection executed in the receiver 3 of Fig. 1;

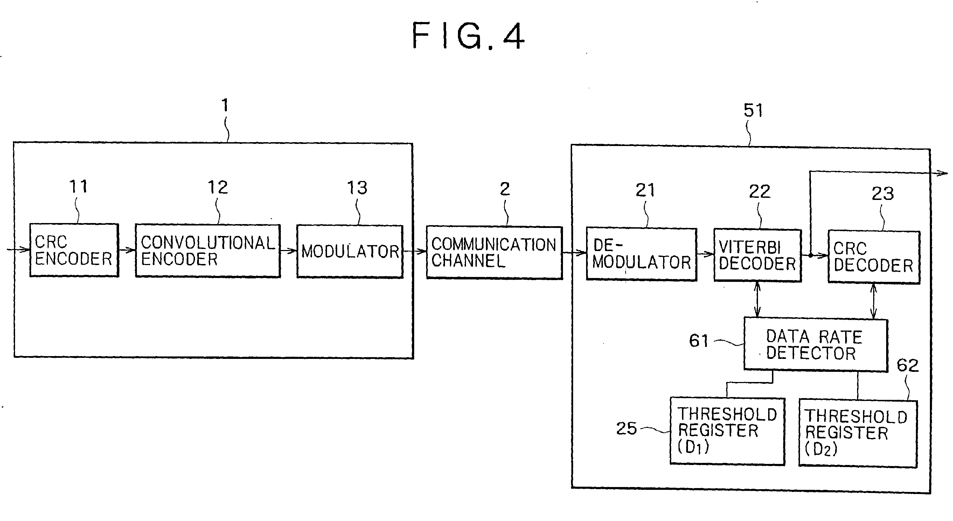

Fig. 4 is a block diagram showing a structural example of an receiver where an embodiment of the present invention is applied;

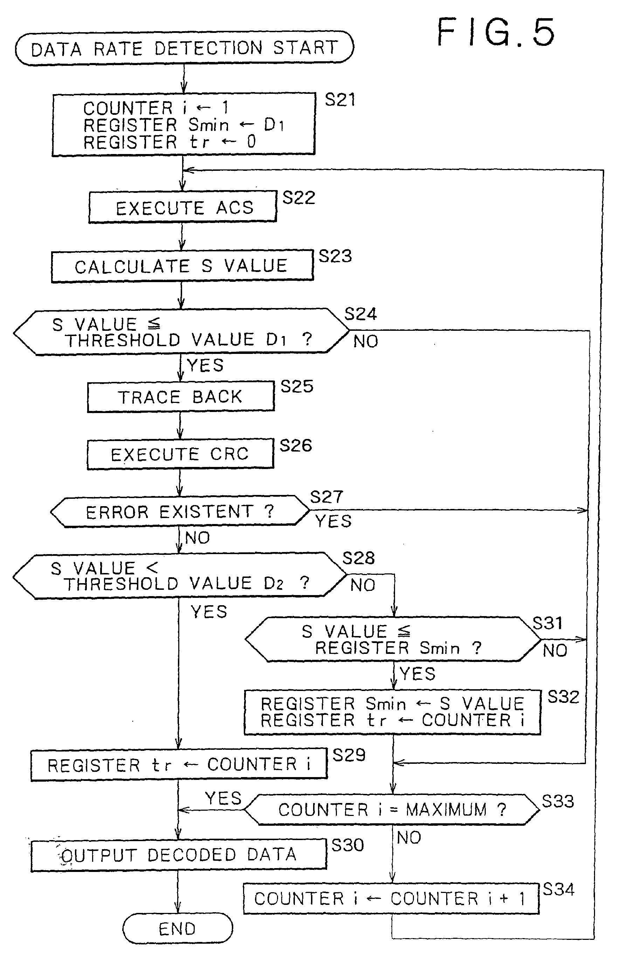

Fig. 5 is a flowchart for explaining a processing routine of data rate detection executed in the receiver 51 of Fig. 4;

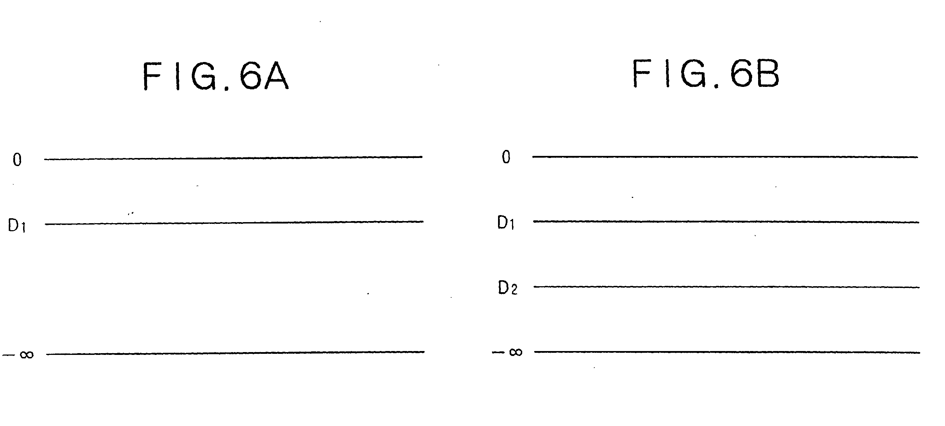

Figs. 6A and 6B are diagrams for explaining threshold values D1 and D2; and

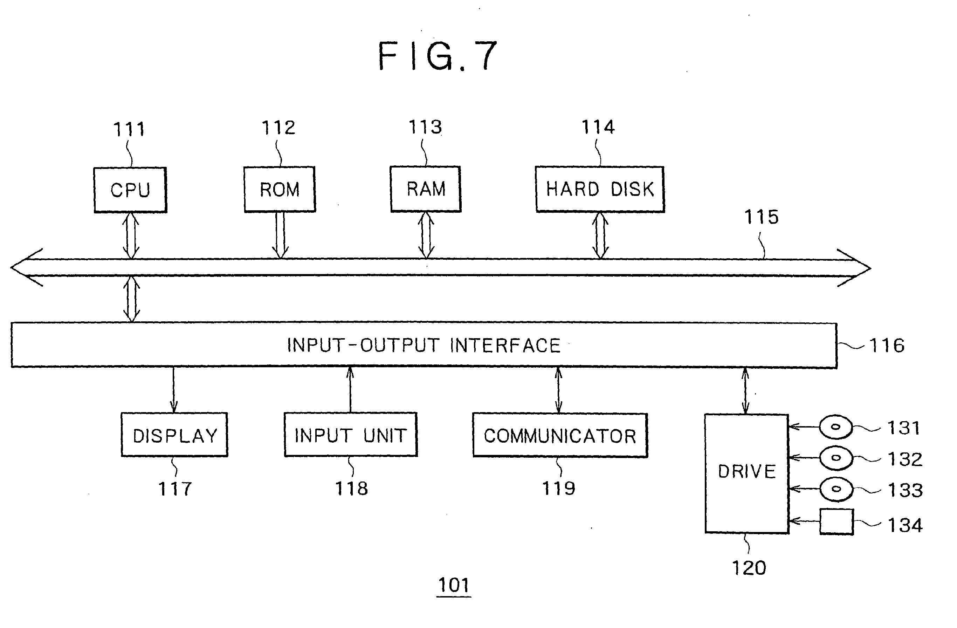

Fig. 7 is a block diagram showing a structural example of a computer 101.

Hereinafter some preferred embodiments of the present invention will be described in detail with reference to the accompanying drawings.

Fig. 4 shows a structural example of a communication system including a receiver 51 to which an embodiment of the present invention is applied, wherein data are transmitted and received at a desired one of plural predetermined data rates. In this diagram, any component blocks corresponding to those shown in Fig. 1 are denoted by the same reference numerals, and a repeated explanation thereof will be omitted in the following description.

The receiver 51 has a data rate detector 61 instead of the aforementioned data rate detector 24 in the receiver 3 of Fig. 1, and also has a second threshold register 62 in addition to the aforementioned first threshold register 25. The receiver 51 executes Viterbi decoding for the data transmitted thereto from the transmitter 1 via the communication channel 2 (e.g., as in Fig. 2). The receiver 51 detects the data rate of the received data through an undermentioned process of data rate detection, and then outputs the decoded data at the detected data rate to an unshown device. Although two threshold values D1 and D2 are stored in separate registers individually, it is a matter of course that D1 and D2 may be stored at separate addresses in one register.

Now the operation of the receiver 51 performed in executing the data rate detection will be described below with reference to a flowchart of Fig. 5. It is supposed here that, as shown in Fig. 2, four data rates $Ri$ (where $i = 1, 2, 3, 4$) are existent.

First at step S21, the data rate detector 61 initializes an internal counter $i$ to 1, a register Smin to D1 which is a predetermined threshold value stored in a threshold register 25, and a register $tr$ to 0, respectively.

At step S22, the data rate detector 61 controls the Viterbi decoder 22 to calculate the maximum pathmetric value, the minimum pathmetric value and the zero-state pathmetric value in the range from the first bit S to the last bit $n_{end}$ of the data rate $Ri$ identified by the value of the counter $i$.

Subsequently the Viterbi decoder 22 executes an ACS process including addition, comparison and selection, thereby calculating the maximum pathmetric value, the minimum pathmetric value and the zero-state pathmetric value. Then the Viterbi decoder 22 supplies the calculated data to the data rate detector 61.

The receiver 51 (data rate detector 61) recognizes the probable data rate $Ri$ in advance and is capable of identifying the data rate $Ri$ by the value of the counter $i$.

In this example, the data rate R1, R2, R3 or R4 is identified when the counter $i$ indicates a value 1, 2, 3 or 4 (maximum) ($i = 1, 2, 3, 4$), so that the data rates are identified in order from the minimum data rate R1 as the value of the counter $i$ is increased one by one from 1 to 4 (at step S34 mentioned later).

Thereafter at step S23, the data rate detector 61 executes the calculation of Eq. (1) on the basis of the maximum pathmetric value, minimum pathmetric value and zero-state pathmetric value supplied from the Viterbi decoder 22 at step S22, thereby obtaining an S value.

At step S24, the data rate detector 61 makes a decision as to whether the S value calculated at step S23 is equal to or smaller than the threshold value D1 or not. The operation proceeds to step S25 in case the result of the above decision signifies that the S value is equal to or smaller than the threshold value D1, i.e., when the data rate Ri identified by the value of the counter i at this time can be regarded as the true data rate of the received data (when there is a probability of the true data rate).

At step S25, the data rate detector 61 controls the Viterbi decoder 22 to execute a traceback process, thereby generating a data stream which ranges from the first bit S to the last bit $n_{end}$ of the data rate Ri identified by the value of the counter i (e.g., to the Elst bit when the value of the counter i is 1). Subsequently at step S26, the data rate detector 61 controls the CRC decoder 23 to make a CRC decision with respect to the decoded data.

Thus, the Viterbi decoder 22 generates a data stream ranging from the first bit S to the last bit $n_{end}$ of the data rate Ri, and then supplies the data stream to the CRC decoder 23.

The CRC decoder 23 divides the decoded data supplied from the Viterbi decoder 22 (i.e., the decoded data from the first bit S to the last bit $n_{end}$ of the data rate Ri) by a generation polynomial, then finds the remainder thereof, and notifies the data rate detector 61 of the remainder as a result of the CRC calculation.

Next at step S27, the data rate detector 61 makes a decision as to whether any error is existent or not in the received data, on the basis of the CRC calculation result obtained from the CRC decoder 23. And if the result of the above decision signifies that no error is existent, the operation proceeds to step S28, where the data rate detector 61 makes a decision as to whether the S value calculated at step S23 is smaller than the threshold value D2 stored in the threshold register 62. The threshold value D2 is set to be smaller than the threshold value D1. For example, the two threshold values are set practically as D1 = -2dB and D2 = -10dB. It has been confirmed by simulation that these values are suited for reducing the error detection rate and achieving efficient detection of the data rate.

In case the result of the decision at step S28 signifies that the S value is smaller than the threshold value D2, the operation proceeds to step S29, where the data rate detector 61 replaces the value of the register tr with the value of the counter i obtained this time. Thereafter the operation proceeds to step S30, where the data rate detector 61 detects the data rate Ri, which is identified by the value of the register tr, as the true data rate of the received data. Then the data rate detector 61 controls the Viterbi decoder 22 to output the decoded data at the detected data rate Ri. The processing routine is thus completed.

Meanwhile, if the result of the decision at step S28 signifies that the S value is not smaller than the threshold value D2, the operation proceeds to step S31, where the data rate detector 61 makes another decision as to whether the S value calculated at step S23 is equal to or smaller than the value of the register Smin. That is, a decision is made as to whether the S value calculated this time is the minimum of the entire S values calculated heretofore.

In case the result of the decision at step S31 signifies that the calculated S value is equal to or smaller than the value of the register Smin, the operation proceeds to step S32, where the data rate detector 61 replaces the value of the register Smin with the S value calculated this time. Further the data rate detector 61 replaces the value of the register tr with that of the counter i obtained at this time.

The operation proceeds to step S33 if the result of the decision at step S24 signifies that the S value is not equal to or smaller than the threshold value D1, or if the result of the decision at step S27 signifies that any error is existent, or if the result of the decision at step S31 signifies that the S value is not equal to or smaller than the value of the register Smin, or if the values of the registers Smin and tr have been replaced at step S32.

The data rate detector 61 makes a decision at step S33 as to whether the value of the counter i is maximum (value 4) or not. And if the result of this decision signifies that the counter value is not maximum, the operation proceeds to step S34, where the counter value is increased by 1. Then the operation returns to step S22, and the subsequent processes are executed.

Meanwhile, in case the result of the decision at step S33 signifies that the value of the counter i is maximum, the operation returns to step S30.

More specifically, in the related art known heretofore, the S value is compared merely with the threshold value D1 which is relatively great as shown in Fig. 6A, so that it becomes necessary to execute the processes of step S2 and and subsequent ones (Fig. 1) with respect to the entire data rates Ri for detection of the desired data rate Ri having the minimum S value. In embodiments of the present invention, when the S value is smaller than the threshold value D1 as shown in Fig. 6B, the data rate having such S value is compared also with the threshold value D2 which is proper for regarding the same as the true data rate of the received data. Therefore, if the data rate Ri having the S value smaller than the threshold value D2 has been detected (i.e., if the result of the decision at step S28 is affirmative or YES), it is possible to immediately regard the relevant data rate Ri as the true data rate of the received data. Consequently, it is no longer necessary, in embodiments of the present invention, to execute the remaining processes for finding the S value with respect to the other data rates Ri, hence achieving efficient detection of the data rate of the received data.

The processing routine mentioned above can be carried out by software as well as by hardware. In the case of carrying out the processing routine by software, a program constituting such software is installed in a computer, and the program is executed by the computer to eventually realize the above-described receiver 51 functionally.

Fig. 7 is a block diagram showing a structural example of a computer 101 which represents an embodiment to function as the above-described receiver 51. An input-output interface 116 is connected to a CPU (central processing unit) 111 via a bus 115. In response to a command sent to the CPU 111 via the input-output interface 116 from an input unit 118 such as a keyboard, a mouse or the like manipulated by a user, the CPU 111 loads into a RAM (random access memory) 113 the program which is stored in a ROM (read only memory) 112, a hard disk 114, or a recording medium mounted on a drive 120, such as a magnetic disk 131, an optical disk 132, a magneto-optical disk 133 or a semiconductor memory 134. And then the CPU 111 executes the program thus loaded, whereby the aforementioned processing routine (e.g., the routine shown in the flowchart of Fig. 5) is carried out. Further the CPU 111 delivers, when necessary, the result via the input-output interface 116 to a display device 117 consisting of an LCD (liquid crystal display) or the like. The program may be stored previously in the hard disk 114 or the ROM 112 so as to be provided for the user together with the computer 101, or may be provided as package media including the magnetic disk 131, optical disk 132, magneto-optical disk 133 and semiconductor memory 134, or may be provided to the hard disk 114 from a satellite, network or the like via the communicator 119.

In this specification, the steps that describe the program provided by the recording medium are executed in time series in accordance with the mentioned sequence, or may be executed in parallel or individually without being restricted to the time series processing.

Although the present invention has been described hereinabove with reference to some preferred embodiments thereof, it is to be understood that the invention is not limited to such embodiments alone, and a variety of other changes and modifications will be apparent to those skilled in the art without departing from the spirit of the invention.

The scope of the invention, therefore, is-to be determined solely by the appended claims.

In so far as the embodiments of the invention described above are implemented, at least in part, using software-controlled data processing apparatus, it will be appreciated that a computer program providing such software control and a transmission, storage or other medium by which such a computer program is provided are envisaged as aspects of the present invention.

**Claims**

1. A signal processing apparatus to perform maximum likelihood decoding for the data transmitted thereto at one of plural predetermined data rates, comprising:

an execution means for selecting said plural data rates in a predetermined order, and executing a maximum likelihood decoding process to regard the data rate of received data as the selected data rate;
a calculation means for calculating a predetermined decision value on the basis of a predetermined metric value obtained through the maximum likelihood decoding process;
a first decision means for comparing the decision value with a first threshold value, and making a decision, on the basis of the result of such comparison, as to whether the data rate selected by said execution means is the data rate of the received data;
a second decision means for comparing the decision value with a second threshold value in response to the result of the decision by said first decision means signifying that the selected data rate is the data rate of the received data, and making a decision, on the basis of the result of such comparison, as to whether the data rate selected by said execution means is the data rate of the received data; and
an output means for delivering the output data decoded by said execution means at the data rate selected by said execution means, in response to the result of the decision by said second decision means signifying that the selected data rate is the data rate of the received data.

2. The signal processing apparatus according to claim 1, wherein said calculation means is capable of calculating the decision value from an equation of: decision value = 10 log ((zero-state pathmetric value-minimum pathmetric value)/(maximum pathmetric value-minimum pathmetric value)).

3. The signal processing apparatus according to claim 1, further comprising:

a means for generating a data stream from the first bit to the last bit of the decided data rate, in response to the decision by said first decision means signifying the data rate of the received data; and
a CRC decision means for making an error decision with respect to said data stream;

wherein said second decision means compares the decision value with the second threshold value on the basis of the result obtained from said CRC decision means.

4. The signal processing apparatus according to claim 3, wherein said second decision means compares the decision value with the second threshold value in case the result obtained from said CRC decision means signifies that no error is existent in said data stream.

5. The signal processing apparatus according to claim 1, wherein the second threshold value is smaller than the first threshold value.

6. A signal processing method carried out in a signal processing apparatus to perform maximum likelihood decoding for the data transmitted thereto at one of plural predetermined data rates, comprising:

an execution step of selecting said plural data rates in a predetermined order, and executing a maximum likelihood decoding process to regard the data rate of received data as the selected data rate;
a calculation step of calculating a predetermined decision value on the basis of a predetermined metric value obtained through the maximum likelihood decoding process;
a first decision step of comparing the decision value with a first threshold value, and making a decision, on the basis of the result of such comparison, as to whether the data rate selected at said execution step is the data rate of the received data;
a second decision step of comparing the decision value with a second threshold value in response to the result of the decision at said first decision step signifying that the selected data rate is the data rate of the received data, and making a decision, on the basis of the result of such comparison, as to whether the data rate selected at said execution step is the data rate of the received data; and
an output step of delivering the output data decoded at said execution step at the data rate selected at said execution step, in response to the result of the decision at said second decision step signifying that the selected data rate is the data rate of the received data.

7. A recording medium containing a recorded program readable by a computer in a signal processing apparatus to perform maximum likelihood decoding for the data transmitted thereto at one of plural predetermined data rates, said program comprising:

an execution step of selecting said plural data rates in a predetermined order, and executing a maximum likelihood decoding process to regard the data rate of received data as the selected data rate;
a calculation step of calculating a predetermined decision value on the basis of a predetermined metric value obtained through the maximum likelihood decoding process;
a first decision step of comparing the decision value with a first threshold value, and making a decision, on the basis of the result of such comparison, as to whether the data rate selected at said execution step is the data rate of the received data;
a second decision step of comparing the decision value with a second threshold value in response to the result of the decision at said first decision step signifying that the selected data rate is the data rate of the received data, and making a decision, on the basis of the result of such comparison, as to whether the data rate selected at said execution step is the data rate of the received data; and
an output step of delivering the output data decoded at said execution step at the data rate selected at said execution step, in response to the result of the decision at said second decision step signifying that the selected data rate is the data rate of the received data.

# F I G. 1

**1**

11 CRC ENCODER

12 CONVOLUTIONAL ENCODER

13 MODULATOR

**2** COMMUNICATION CHANNEL

**3**

21 DE-MODULATOR

22 VITERBI DECODER

23 CRC DECODER

24 DATA RATE DETECTOR

25 THRESHOLD REGISTER ($D_1$)

FIRST BIT S     $n_{end}$ = E1st BIT

F I G. 2A     DATA RATE R1     | DATA STREAM | CRC | EMPTY |

FIRST BIT S     $n_{end}$ = E2nd BIT

F I G. 2B     DATA RATE R2     | DATA STREAM | CRC | EMPTY |

FIRST BIT S     $n_{end}$ = E3rd BIT

F I G. 2C     DATA RATE R3     | DATA STREAM | CRC | EMPTY |

FIRST BIT S     $n_{end}$ = E4th BIT

F I G. 2D     DATA RATE R4     | DATA STREAM | CRC |

EP 1 187 342 A2

# F I G . 3

DATA RATE DETECTION START

COUNTER i ← 1
REGISTER Smin ← $D_1$
REGISTER tr ← 0    **S1**

EXECUTE ACS    **S2**

CALCULATE S VALUE    **S3**

S VALUE ≦
THRESHOLD VALUE $D_1$ ?    **S4**
→ NO

YES

TRACE BACK    **S5**

EXECUTE CRC    **S6**

ERROR EXISTENT ?    **S7**
YES →

NO

S VALUE ≦
REGISTER Smin ?    **S8**
NO →

YES

REGISTER Smin ← S VALUE
REGISTER tr ← COUNTER i    **S9**

COUNTER i ← COUNTER i + 1    **S11**

COUNTER i = MAXIMUM ?    **S10**
NO

YES

OUTPUT DECODED DATA    **S12**

END

11

# FIG.4

CRC ENCODER `11` → CONVOLUTIONAL ENCODER `12` → MODULATOR `13` (block `1`)

COMMUNICATION CHANNEL `2`

DE-MODULATOR `21` → VITERBI DECODER `22` → CRC DECODER `23` (block `51`)

DATA RATE DETECTOR `61`

THRESHOLD REGISTER ($D_1$) `25`  THRESHOLD REGISTER ($D_2$) `62`

# FIG.5

```
            ( DATA RATE DETECTION START )
                         │
                         ▼
            ┌─────────────────────────────┐
            │  COUNTER i ← 1              │  S21
            │  REGISTER Smin ← D₁         │
            │  REGISTER tr ← 0           │
            └─────────────────────────────┘
                         │
                         ▼
            ┌─────────────────────────────┐
            │       EXECUTE ACS           │  S22
            └─────────────────────────────┘
                         │
                         ▼
            ┌─────────────────────────────┐
            │     CALCULATE S VALUE       │  S23
            └─────────────────────────────┘
                         │
                         ▼
            ╱─────────────────────────────╲  S24
           ⟨  S VALUE ≦                    ⟩──── NO ────┐
            ╲  THRESHOLD VALUE D₁ ?        ╱             │
                         │ YES                           │
                         ▼                               │
            ┌─────────────────────────────┐              │
            │       TRACE BACK            │  S25         │
            └─────────────────────────────┘              │
                         │                               │
                         ▼                               │
            ┌─────────────────────────────┐              │
            │       EXECUTE CRC           │  S26         │
            └─────────────────────────────┘              │
                         │                               │
                         ▼                               │
            ╱─────────────────────────────╲  S27         │
           ⟨   ERROR EXISTENT ?            ⟩── YES ───────┤
            ╲─────────────────────────────╱              │
                         │ NO                            │
                         ▼                               │
            ╱─────────────────────────────╲  S28         │
           ⟨  S VALUE <                    ⟩─ NO ─┐       │
            ╲  THRESHOLD VALUE D₂ ?        ╱      │       │
                         │ YES                    ▼       │
                         │       ╱──────────────────────╲ S31
                         │      ⟨  S VALUE ≦             ⟩── NO ──┤
                         │       ╲  REGISTER Smin ?      ╱        │
                         │                  │ YES                 │
                         │                  ▼                     │
                         │      ┌──────────────────────────┐      │
                         │      │ REGISTER Smin ← S VALUE   │ S32  │
                         │      │ REGISTER tr ← COUNTER i   │      │
                         │      └──────────────────────────┘      │
                         ▼                  │                     │
   ┌──────────────────────────┐             │                     │
   │ REGISTER tr ← COUNTER i   │ S29         │                     │
   └──────────────────────────┘             │                     │
                         │                  ▼                     │
            ┌─ YES ──╱──────────────────────────╲ S33             │
            │       ⟨  COUNTER i = MAXIMUM ?     ⟩                │
            │        ╲──────────────────────────╱                │
            ▼                     │ NO                            │
   ┌──────────────────────────┐   ▼                               │
   │  OUTPUT DECODED DATA      │ S30  ┌──────────────────────────┐ │
   └──────────────────────────┘      │ COUNTER i ← COUNTER i + 1 │ S34
            │                        └──────────────────────────┘ │
            ▼                                    │                 │
          ( END )                                └─────────────────┘
```

# FIG.6A

0

$D_1$

$-\infty$

# FIG.6B

0

$D_1$

$D_2$

$-\infty$

EP 1 187 342 A2

# FIG.7

EP 1 187 342 A2